# EUROPÄISCHE PATENTSCHRIFT

(11) **EP 0 707 218 B1**
(45) Veröffentlichungstag und Bekanntmachung des Hinweises auf die Patenterteilung: **19.12.2001**
(21) Anmeldenummer: 95113138.2
(22) Anmeldetag: 22.08.1995
(51) Int. Cl.: G01R 33/09

(54) **Sensorchip**
Sensor chip
Capteur en puce

(30) Priorität: 15.10.1994 DE 4436876
(43) Veröffentlichungstag der Anmeldung: 17.04.1996
(73) Patentinhaber: Lust Antriebstechnik GmbH, 35633 Lahnau (DE)
(72) Erfinder: Dettmann, Fritz, D-35764 Sinn-Edingen (DE); Loreit, Uwe, D-35580 Wetzlar (DE); Kunze, Jürgen, D-35585 Wetzlar (DE); Lust, Karl-Heinz, D-35633 Lahnau (DE)
(74) Vertreter: Missling, Arne, Dipl.-Ing.

(56) Entgegenhaltungen:
- DE-A- 4 300 605
- DE-A- 4 318 716
- DE-A- 4 319 146
- US-A- 4 835 510

## Beschreibung

Die Erfindung betrifft einen Sensorchip mit einer Brückenschaltung in Form einer Wheatstone-Brücke zum Messen von Gradienten der magnetischen Feldstärke, bestehend aus vier magnetoresistiven und in zwei Bereichen mit Abstand zu einer gemeinsamen Mittenachse symmetrisch angeordneten Widerständen, von denen je zwei in Reihe geschaltete Widerstände jeweils einen Brückenzweig der Wheatstone-Brücke bilden, wobei die Widerstände als magnetoresistive Schichtstreifen ausgebildet sind, sowie eine Anordnung zum Messen von elektrischen Strömen mit Hilfe eines solchen Sensorchips.

Ein Sensorchip dieser Art ist aus der Patentschrift DE 42 12 737 C1 bereits bekannt.

Meßanordnungen zur Bestimmung von Magnetfeldgradienten dienen insbesondere zur potentialfreien Messung der Stromstärke eines elektrischen Stromes, der ein derartiges Magnetfeld hervorruft. Da die gesamte Umgebung eines auf diese Weise zu bestimmenden Magnetfeldes stets schon mit großräumigen Störmagnetfeldern behaftet ist, liegt es nahe, mit Hilfe von Magnetfeldgradienten zwischen dem auszumessenden und einem Störmagnetfeld zu unterscheiden.

Solche Anordnungen sind aus den Patentschriften DD 155 220 und DD 275 745 ebenfalls bereits bekannt. Dabei werden magnetoresistive Sensorelemente eingesetzt, da deren Empfindlichkeit groß genug ist, um Ströme über einen großen Messbereich nachzuweisen. Der Linearitätsbereich derartiger Sensorelemente ist allerdings begrenzt. Ihre an und für sich hohe Empfindlichkeit ist stark von der Temperatur und von einem an den Sensorelementen anzubringenden Hilfsmagnetfeld abhängig. Die Empfindlichkeit der einzelnen Sensorelemente ist darüber hinaus sehr unterschiedlich.

Eine weitere Anordnung der genannten Art zur Bestimmung von Strömen aus dem von ihnen erzeugten Magnetfeldgradienten ist in der EP 0 286 079 offenbart. Der Sensorchip umschließt hier den stromführenden Leiter konzentrisch. Die Sensorebene erstreckt sich senkrecht zur Stromrichtung. Die Widerstände des Brückensensors sind aus Mäandern von magnetoresistiven Schichtstreifen mit Barberpol-Struktur aufgebaut. Alle Schichtstreifen erstrecken sich in radialer Richtung um den Strom. Jeder Brückenwiderstand nimmt ein Viertel des Umfanges ein, so dass die gesamte Anordnung sich auf einem Kreisring um den Stromleiter befindet. Ein Vorteil der Anordnung ist, dass das Magnetfeld des Stromes überall senkrecht zur Längsrichtung der magnetoresistiven Schichtstreifen steht und so das größtmögliche Sensorsignal bei einem bestimmten Strom erhalten wird.

In der Patentanmeldung P 43 00 605.1-35 der Anmelderin ist deshalb ein Sensorchip angegeben, bei dem das Ausgangssignal einem auszumessenden elektrischen Strom proportional, dessen Empfindlichkeit weder temperatur- noch hilfsfeldabhängig sein und der stets eine etwa gleiche Empfindlichkeit aufweisen soll. Zur Kompensation der Störgrößen geht dabei diese Anordnung davon aus, dass die Bereiche jeweils einen Widerstand des einen und einen Widerstand des anderen Brückenzweiges umfassen und diese symmetrisch zur Mittelachse angeordnet sind.

Die Erfindung übernimmt den Gedanken der symmetrischen Anordnung der Schichtstreifen und hat sich die Aufgabe gestellt, einen eingangs näher bezeichneten Sensorchip bezüglich seiner Abhängigkeit von einem an ihm wirksamen Temperaturgradienten zu verbessern und eine Anordnung zum Messen von elektrischen Strömen mit Hilfe eines solchen Sensorchips anzugeben. Das Ausgangssignal soll dabei einem auszumessenden elektrischen Strom proportional und die Empfindlichkeit des Sensorchips weder temperatur- noch hilfsfeldabhängig und stets etwa konstant sein.

Diese Aufgabe wird für den Sensorchip durch die im Anspruch 1 und für eine Anordnung zum Messen von elektrischen Strömen mit Hilfe eines Sensorchips durch die im Anspruch 17 angegebenen Merkmale gelöst.

Besondere Ausführungsarten der Erfindung sind Gegenstand der Unteransprüche.

Die Erfindung löst die Aufgabenstellung in überraschend einfacher Weise. Das Ausgangssignal des Sensorchips hat einen unbegrenzten Linearitätsbereich und ist weder temperatur- noch hilfsmagnetfeldabhängig. Die Exemplarstreuung ist äußerst gering, da die Topographie des Sensorchips mit Hilfe der Mikrostrukturierung sehr präzise gefertigt werden kann.

Da der Abstand der beiden Bereiche, das heißt die Basislänge des Gradiometers, klein gehalten werden kann, ist auch die Beeinflussung durch Störmagnetfelder unerheblich, deren Quellen einen von der Meßanordnung dagegen großen Abstand haben.

Eine Anordnung mit einem erfindungsgemäßen Sensorchip besitzt einen hohen Grad an geometrischer Symmetrie als Voraussetzung für eine symmetrische Erwärmung des Sensorchips im Betrieb. Die spiegelbildliche Ausführung der paarweisen, parallel geschalteten Schichtstreifen schaltet einen Temperaturgradienten gleich im selben Brückenzweig aus, so daß eine spätere Kompensation entfällt. Durch die betriebsstromverursachte symmetrische Temperaturerhöhung wird in allen Schichtstreifen der Wheatstone-Brücke eine gleiche Drehung der Magnetisierung und infolgedessen eine gleiche Widerstandsänderung hervorgerufen. Damit ist, über die eigentliche Aufgabenstellung der Erfindung hinaus, auch die temperaturabhängige Nullpunktdrift in dem Sensorchip weitgehend beseitigt.

Die Erfindung wird nachstehend anhand der Zeichnung an einem Ausführungsbeispiel näher erläutert. Es zeigen
- Fig. 1: eine Wheatstone-Brücke nach dem Stand der Technik,
- Fig. 2: einen Sensorchip gemäß der Erfindung,
- Fig. 3: die Verbindung eines erfindungsgemäßen Sensorchips mit einer Stromleitung zur Messung des in dieser fließenden Stromes und
- Fig. 4: die Ausbildung der Anschlußkontakte und der Stromführung bei einer Anordnung entsprechend Fig. 3.

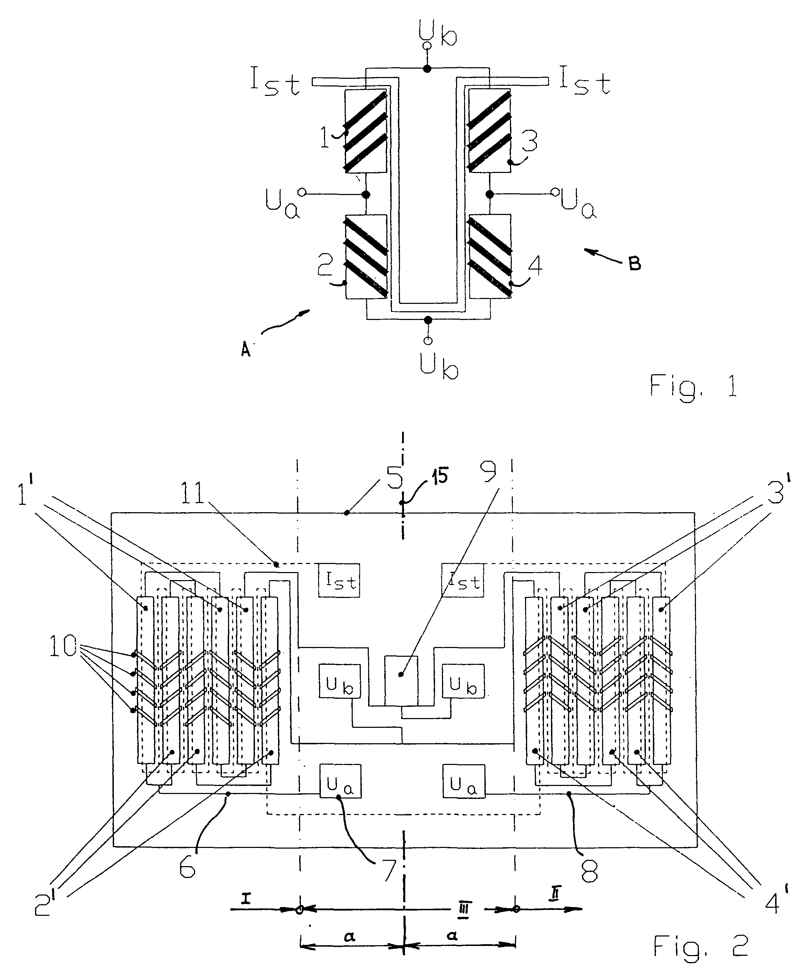

In Fig. 1 ist eine Brückenschaltung in Form einer Wheatstone-Brücke gezeigt, bei der zwei magnetoresistive Widerstände 1 und 2 in einem ersten Brückenzweig A und zwei weitere magnetoresistive Widerstände 3 und 4 in einem zweiten Brückenzweig B, jeweils in Reihe geschaltet, angeordnet sind. Die Wheatstone-Brücke wird mit einer Betriebsspannung U_{b} versorgt, als Ausgangssignal dient die Ausgangsspannung Uₐ. Unter mindestens einem der Widerstände 1 bis 4 ist ein gegen diesen isolierter Dünnschicht-Streifenleiter vorgesehen; um gleiche Bauteile zu erhalten, ist es naheliegend, daß unter jedem der Widerstände 1 bis 4 ein Dünnschicht-Streifenleiter vorgesehen ist. Die Dünnschicht-Streifenleiter, die in der Zeichnung weggelassen sind, weil ihre Anordnung dem Fachmann geläufig ist, werden durch die Steuerleitung 11 von dem Steuerstrom Iₛₜ durchflossen. Eine derartige Anordnung entspricht dem Stand der Technik.

Die Einzelheiten des erfindungsgemäßen Sensorchips sind in der Darstellung der Fig. 2 zu erkennen. Der Sensorchip 5 umfaßt zwei Bereiche I und II, die gleich weit mit dem Abstand a von einer Mittelachse 15 beginnend jeweils zwei magnetoresistive Widerstände 1;2 und 3;4 umfassen. Die Widerstände 1, 2, 3, 4 bestehen ihrerseits aus jeweils drei unter sich und zu den übrigen parallelen Schichtstreifen 1', 2', 3', 4' die in bekannter Weise mit Barberpol-Strukturen 10 sind. Die Barberpol-Strukturen 10 sind bei allen Widerständen 1, 2, 3, 4 spiegelbildlich gleich. Dadurch ist dafür gesorgt, daß nur ein anliegender Feldgradient die Brücke aussteuert. Nach wie vor befinden sich die Widerstände 1; 2 und die Widerstände 3; 4 jeweils auf ein und demselben Brückenzweig A;B; in den Bereichen I und II sind jeweils zwei Widerstände 1; 2 und 3; 4 aus den Brückenzweigen A;B räumlich zusammengefaßt. Dies wird auch durch die eingezeichneten elektrischen Leitungen 6 zwischen den Schichtstreifen 1', 2', 3', 4' und den von den Schichtstreifen 1', 2', 3', 4' nach außen führenden Leitungen 8 deutlich. Die Leitungen 8 verbinden Flächenstücke 7 mit den Schichtstreifen 1', 2', 3', 4'. Die Flächenstücke 7 bilden, in einer Ebene gelegen, aus dem Sensorchip 5 herausführende Kontakte für die Betriebsspannung U_{b} und die Ausgangsspannung Uₐ. Zwei weitere Flächenstücke 7 dienen als Außenkontakte für die Zuführung des Steuerstromes Iₛₜ. Die Flächenstücke 7 sind im zentralen Bereich III des Sensorchips 5 symmetrisch zur Mittelachse 15 angeordnet.

Im Bereich dieser Mittelachse 15 befindet sich weiterhin ein änderbarer Widerstand 9, der in der dargestellten Weise mit den Brückenzweigen A; B der Wheatstone-Brücke in Reihe geschaltet ist. Der Widerstand 9 kann mechanisch oder mittels Laser abgetragen werden, wobei diese Abtragung so erfolgt, daß die Symmetrie der Gesamtanordnung erhalten wird.

Die Ausgangsspannung Uₐ wird einem nicht gezeichneten Verstärker zugeführt. Dessen Ausgang, der Steuerstrom Iₛₜ, wird so eingestellt, daß die Wirkung des äußeren Magnetfeldgradienten am Ort der Schichtstreifen 1', 2', 3', 4' aufgehoben ist. Der Steuerstrom Iₛₜ bildet das Ausgangssignal der Anordnung. Er ist dem Magnetfeldgradienten direkt proportional und ist nicht von der Temperatur und von großräumigen Störmagnetfeldern abhängig. Durch die erfindungsgemäße Anordnung der weitgehenden Achssymmetrie am Sensorchip 5 ist dafür gesorgt, daß die auftretende Erwärmung in Symmetrie zur Mittelachse 15 erfolgt. Die durch Magnetostriktion bewirkten Widerstandsänderungen in den Schichtstreifen 1', 2', 3', 4' sind deshalb überall gleich und bewirken keine Änderung der Ausgangsspannung Uₐ. Eine Nullpunktdrift in Abhängigkeit der Temperatur ist damit weitgehend unterdrückt. Auch das Trimmen der Wheatstone-Brücke erfolgt in achssymmetrischer Weise, da der Widerstand 9 in der Mittelachse 15 angeordnet ist. Auf diese Weise läßt sich die Ausgangsspannung Uₐ in Richtung Null einstellen, wenn kein Magnetfeldgradient vorhanden ist.

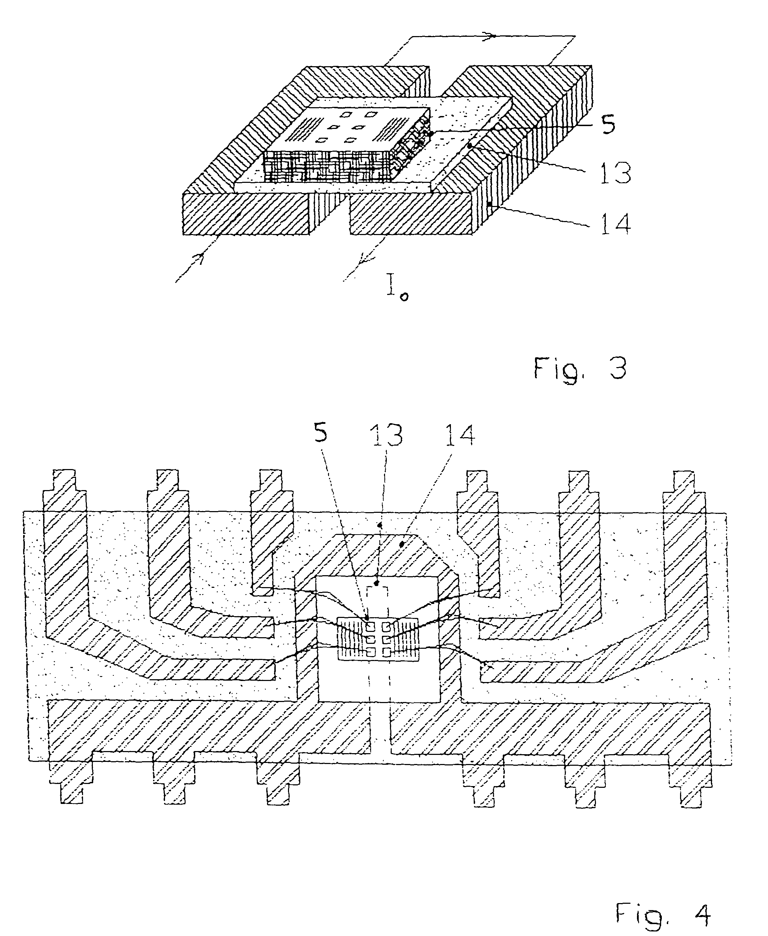

Die Fig. 3 und 4 zeigen die Anwendung eines erfindungsgemäßen Sensorchips 5 bei der Messung der Stromstärke Iₒ eines elektrischen Stromes Iₒ durch eine Leitung 14. Der Sensorchip 5 ist gegen die Leitung 14 durch eine Isolierung 13 elektrisch getrennt. Es sind zwei Leitungen 14 vorgesehen, die vom Strom Iₒ in der in Fig. 3 dargestellten Weise durchflossen werden. Dadurch entsteht ein Magnetfeldgradient, der dem Strom Iₒ in der Leitung 14 proportional ist. Störmagnetfelder, die durch in der Nähe vorbeifließende andere Ströme hervorgerufen sein können, haben auf das Ausgangssignal, den Steuerstrom Iₛₜ, keine Wirkung, da ihr Magnetfeld auf die beiden symmetrischen Bereiche I und II in gleichem Maße einwirkt. Dazu trägt bei, daß die Abstände zwischen den Bereichen I und II kleiner als 1 mm sind.

Die Fig. 4 zeigt ein komplettes Bauelement zur potentialfreien Messung der Stromstärke Iₒ. Beide Leitungen 14 sind hier so geformt, daß wiederum ein Magnetfeldgradient am Ort des Sensorchips 5 entsteht. Die Isolation 13 zwischen dem Sensorchip 5 und der Leitung 14 und die Anordnung der Bauelementepins für den Strom Iₒ und für die Versorgung des Sensorchips 5 auf entgegengesetzten Seiten des Bauelementes sorgen hier für eine hohe Schutzisolationsspannung.

### Aufstellung der verwendeten Bezugszeichen

- 1,2,3,4: (magnetoresistiver) Widerstand
- 1',2',3',4': Schichtstreifen
- 5: Sensorchip
- 6: Leitung
- 7: Flächenstück
- 8: Leitung
- 9: (änderbarer) Widerstand
- 10: Barberpol-Struktur
- 11: Steuerleitung
- 13: Isolierung
- 14: Leitung
- 15: Mittenachse

- I,II,III: Bereich

- a: Abstand

- A,B: Brückenzweig
- Iₒ: Strom, Stromstärke
- Iₛₜ: Steuerstrom
- Uₐ: Ausgangsspannung
- U_{b}: Betriebsspannung

## Patentansprüche

1. Sensorchip mit einer Brückenschaltung in Form einer Wheatstone-Brücke zum Messen von Gradienten der magnetischen Feldstärke, bestehend aus vier magnetoresistiven und in zwei Bereichen (I, II) mit Abstand (a) zu einer gemeinsamen Mittelachse (15) symmetrisch angeordneten Widerständen (1, 2, 3, 4), von denen je zwei in Reihe geschaltete Widerstände (1u. 2; 3 u. 4) jeweils einen Brückenzweig (A, B) der Wheatstone-Brücke bilden, wobei die Widerstände (1, 2, 3, 4) als magnetoresistive Schichtstreifen (1', 2', 3', 4') mit Barberpol-Struktur (10) ausgebildet sind und die Bereiche (I, II) jeweils die beiden Widerstände (1, 2, 3, 4) ein und desselben Brückenzweiges (A, B) umfassen, die Barberpol-Strukturen (10) aller Schichtstreifen (1', 2', 3', 4') eines Widerstandes stets die gleiche Barberpolorientierung aufweisen und innerhalb eines Bereiches (I, II) die entsprechenden magnetoresistiven Schichtstreifen (1', 2', 3', 4') der beiden Widerstände (1 u. 2; 3 u. 4) des Brückenzweiges (A, B) bezüglich ihrer Barberpol-Struktur (10) spiegelbildlich gleich zueinander ausgeführt sind,
**dadurch gekennzeichnet dass** die Längsachsen aller magnetoresistiven Schichtstreifen (1', 2', 3', 4') parallel zueinander verlaufen, die Widerstände (1, 2, 3, 4) jeweils aus mindestens zwei magnetoresistiven Schichtstreifen (1', 2', 3', 4') bestehen und dass stets je ein magnetoresistiver Schichtstreifen (1'; 2'; 3'; 4') eines jeden Widerstandes (1, 2, 3, 4) paarweise mit einem magnetoresistiven Schichtstreifen (2', 1', 4', 3') des anderen Widerstandes (2, 1, 4, 3) des gleichen Brückenzweiges (A, B) angeordnet ist.

2. Sensorchip nach Anspruch 1, **dadurch gekennzeichnet, dass** sich über oder unter mindestens einem Schichtstreifen (1', 2', 3', 4') ein gegen diesen isolierter Dünnschicht-Streifenleiter befindet, durch den ein messbarer elektrischer Steuerstrom (Iₛₜ) fließen kann.

3. Sensorchip nach Anspruch 2, **dadurch gekennzeichnet, dass** der Steuerstrom (Iₛₜ) so wählbar ist, dass von der Wheatstone-Brücke gemessene Änderungen der magnetischen Feldstärke kompensiert werden.

4. Sensorchip nach Anspruch 2 oder 3, **dadurch gekennzeichnet, dass** mehrere Dünnschicht-Streifenleiter vorgesehen sind.

5. Sensorchip nach Anspruch 5, **dadurch gekennzeichnet, dass** über oder unter jedem Schichtstreifen der Widerstände (1 bis 4) ein Dünnschicht-Streifenleiter vorgesehen ist.

6. Sensorchip nach Anspruch 5, **dadurch gekennzeichnet, dass** die Dünnschicht-Streifenleiter symmetrisch zur Mittelachse (15) angeordnet sind.

7. Sensorchip nach einem der Ansprüche 1 bis 6, **dadurch gekennzeichnet, dass** ein änderbarer, magnetoresistiver Widerstand (9) mit den Brückenzweigen (A; B) der Wheatstone-Brücke in Reihe geschaltet ist.

8. Sensorchip nach einem der Ansprüche 1 bis 7, **dadurch gekennzeichnet, dass** auf der Oberfläche des Sensorchips (5) als Flächenstücke (7) ausgeführte Kontakte für die Betriebsspannung (U_{b}) und die Ausgangsspannung (Uₐ) der Wheatstone-Brücke und gegebenenfalls für den Steuerstrom (Iₛₜ) vorgesehen sind.

9. Sensorchip nach Anspruch 8, **dadurch gekennzeichnet, dass** die Flächenstücke (7) symmetrisch zur Mittelachse (15) angeordnet sind.

10. Sensorchip nach Anspruch 9, **dadurch gekennzeichnet, dass** die Flächenstücke (7) im zentralen Bereich (III) des Sensorchips (5) liegen.

11. Sensorchip nach einem der Ansprüche 1 bis 10, **dadurch gekennzeichnet, dass** die magnetoresistiven Schichtstreifen (1', 2', 3', 4') in einer Ebene angeordnet sind.

12. Sensorchip nach Anspruch 11, **dadurch gekennzeichnet, dass** die zwischen den Schichtstreifen (1', 2', 3', 4') und/oder zwischen diesen und den Flächenstücken (7) erforderlichen elektrischen Leitungen (6;8) in der gleichen Ebene angeordnet sind.

13. Sensorchip nach einem der Ansprüche 7 bis 12, **dadurch gekennzeichnet, dass** jeder änderbare Widerstand (9) symmetrisch zur Mittelachse (15) angeordnet ist.

14. Sensorchip nach Anspruch 13, **dadurch gekennzeichnet, dass** der Widerstand (9) durch mechanische Abtragung änderbar ist.

15. Sensorchip nach einem der Anspräche 1 bis 14, **dadurch gekennzeichnet, dass** der zu messende Gradient der magnetischen Feldstärke durch Ströme in einer elektrischen Leitung (14) zustande kommt, die symmetrisch zur Mittelachse (15) des Sensorchips angeordnet und fixiert ist.

## Claims

1. A sensor chip with a bridge circuit in the form of a Wheatstone bridge for the measurement of gradients of the magnetic field intensity, comprising four magnetoresistive resistors (1, 2, 3, 4) arranged symmetrically in two regions (I, II) at a distance (a) from a common central axis (15), in which two pairs of resistors (1 and 2; 3 and 4) connected in series each form a bridge arm (A, B) of the Wheatstone bridge, wherein the resistors (1, 2, 3, 4) are formed as magnetoresistive laminated strips (1', 2', 3', 4') with a barber's pole structure (10) and the regions (I, II) each comprise the two resistors (1, 2, 3, 4) of one and the same bridge arm (A, B), the barber's pole structures (10) of all the laminated strips (1', 2', 3', 4') of a resistor always have the same barber's pole orientation and, within a region (I, II), the corresponding magnetoresistive laminated strips (1', 2', 3', 4') of the two resistors (1 and 2; 3 and 4) of the bridge arm (A, B) are formed mirror-symmetrically to one another with respect to their barber's pole structure (10), **characterised in that** the longitudinal axes of all the magnetoresistive laminated strips (1', 2', 3', 4') extend parallel to one another, the resistors (1, 2, 3, 4) each comprise at least two magnetoresistive laminated strips (1', 2', 3', 4') and **in that** a magnetoresistive laminated strip (1', 2', 3', 4') of each resistor (1, 2, 3, 4) is always arranged in a pair with a magnetoresistive laminated strip (1', 2', 3', 4') of the other resistor (1, 2, 3, 4) of the same bridge arm (A, B).

2. A sensor chip according to claim 1, **characterised in that** a thin-layer strip conductor, through which a measurable electric control current (Iₛₜ) can flow, is arranged above or below at least one laminated strip (1', 2', 3', 4') and is insulated therefrom.

3. A sensor chip according to claim 2, **characterised in that** the control current (Iₛₜ) can be selected so that changes in the magnetic field intensity, measured by the Wheatstone bridge, can be compensated for.

4. A sensor chip according to claim 2 or 3, **characterised in that** a plurality of thin-layer strip conductors are provided.

5. A sensor chip according to claim 5, **characterised in that** a thin-layer strip conductor is provided above or below each laminated strip of the resistors (1 to 4).

6. A sensor chip according to claim 5, **characterised in that** the thin-layer strip conductors are arranged symmetrically to the central axis (15).

7. A sensor chip according to any one of claims 1 to 6, **characterised in that** a variable, magnetoresistive resistor (9) is connected in series to the bridge arm (A, B) of the Wheatstone bridge.

8. A sensor chip according to any one of claims 1 to 7, **characterised in that** contacts, formed as surface elements (7), for the operating voltage (U_{b}) and the output voltage (Uₐ) of the Wheatstone bridge and optionally for the control current (Iₛₜ) are provided on the surface of the sensor chip (5).

9. A sensor chip according to claim 8, **characterised in that** the surface elements (7) are arranged symmetrically to the central axis (15).

10. A sensor chip according to claim 9, **characterised in that** the surface elements (7) lie in the central region (III) of the sensor chip (5).

11. A sensor chip according to any one of claims 1 to 10, **characterised in that** the magnetoresistive laminated strips (1', 2', 3', 4') are arranged in one plane.

12. A sensor chip according to claim 11, **characterised in that** the electric lines (6, 8) required between the laminated strips (1', 2', 3', 4') and/or between the latter and the surface elements (7) are arranged in the same plane.

13. A sensor chip according to any one of claims 7 to 12, **characterised in that** each variable resistor (9) is arranged symmetrically to the central axis (15).

14. A sensor chip according to claim 13, **characterised in that** the resistor (9) is variable by mechanical abrasion.

15. A sensor chip according to any one of claims 1 to 14, **characterised in that** the measured gradient of the magnetic field intensity is generated by currents in an electric line (14) arranged and fixed symmetrically to the central axis (15) of the sensor chip.

## Revendications

1. Puce électronique pour capteur, avec un branchement en pont, sous la forme d'un pont de Wheatstone, pour la mesure des gradients d'intensité de champ magnétique, constitué de quatre résistances (1, 2, 3, 4), de nature magnétorésistive et disposées symétriquement dans deux zones (I, II) sous un espacement (a) par rapport à un axe médian (15) commun, résistances dont chaque fois deux résistances (1 et 2; 3 et 4) branchées en série forment chaque fois une branche de pont (A, B) du pont de Wheatstone, les résistances (1, 2, 3, 4) étant réalisées sous la forme de bandes de couches (1', 2', 3', 4') magnétorésistives, ayant une structure "Barberpol" (10), et les zones (I, II) comprenant chaque fois les deux résistances (1, 2, 3, 4) d'une seule et même branche de pont (A, B), les structures "Barberpol" (10) de toutes les bandes de couches (1', 2', 3', 4') d'une résistance présentant toujours la même orientation "Barberpol" et, à l'intérieur d'une zone (I, II), les bandes de couches (1', 2', 3', 4') magnétorésistives correspondantes des deux résistances (1 et 2; 3 et 4) de la branche de pont (A, B) étant réalisées à l'identique l'une par rapport à l'autre et en répondant à une symétrie spéculaire par rapport à leur structure "Barberpol"(10), **caractérisée en ce que** les axes longitudinaux de toutes les bandes de couches (1', 2', 3', 4') magnétorésistives s'étendent parallèlement entre eux, les résistances (1, 2, 3, 4) étant chaque fois constituées de deux bandes de couches (1', 2', 3', 4') magnétorésistives, et **en ce que** chaque fois une bande de couche (1', 2', 3', 4') magnétorésistive de chaque résistance (1, 2, 3, 4) est toujours disposée par paire, avec une bande de couche (2', 1', 4', 3') magnétorésistive de l'autre résistance (2, 1, 4, 3) de la même branche de pont (A, B).

2. Puce électronique pour capteur selon la revendication 1, **caractérisée en ce que** sur, ou sous, au moins une bande de couche (1', 2', 3', 4') se trouve un conducteur en ruban à couche mince, isolé par rapport à celle-ci, à travers lequel peut passer un courant électrique de commande (Iₛₜ) mesurable.

3. Puce électronique pour capteur selon la revendication 2, **caractérisée en ce que** le courant de commande (Iₛₜ) est choisi de manière que les fluctuations, mesurées par le pont de Wheatstone, de l'intensité du champ magnétique sont compensées.

4. Puce électronique pour capteur selon la revendication 2 ou 3, **caractérisée en ce que** plusieurs conducteurs à ruban en couche mince sont prévus.

5. Puce électronique pour capteur selon la revendication 5, **caractérisée en ce qu'**un conducteur à ruban à couche mince est prévu sur ou sous chaque bande de couche des résistances (1 à 4).

6. Puce électronique pour capteur selon la revendication 5, **caractérisée en ce que** les conducteurs à ruban à couche mince sont disposés symétriquement par rapport à l'axe médian (15).

7. Puce électronique pour capteur selon l'une des revendications 1 à 6, **caractérisée en ce qu'**une résistance (9) magnétorésistive, variable, est connectée en série avec les branches de pont (A; B) du pont de Wheatstone.

8. Puce électronique pour capteur selon l'une des revendications 1 à 7, **caractérisée en ce que**, sur la surface de la puce électronique de capteur (5), sont prévus des contacts, réalisés sous la forme d'éléments de surface (7), pour la tension de service (U_{b}) et la tension de sortie (Uₐ) du pont de Wheatstone et, le cas échéant, pour le courant de commande (Iₛₜ).

9. Puce électronique pour capteur selon la revendication 8, **caractérisée en ce que** les éléments de surface (7) sont disposés symétriquement par rapport à l'axe médian (15).

10. Puce électronique pour capteur selon la revendication 9, **caractérisée en ce que** les éléments de surface (7) sont placés dans la zone centrale (III) de la puce électronique pour capteur (5).

11. Puce électronique pour capteur selon l'une des revendications 1 à 10, **caractérisée en ce que** les bandes de couches (1', 2', 3', 4') magnétorésistives sont disposées dans un plan.

12. Puce électronique pour capteur selon la revendication 11, **caractérisée en ce que** les lignes électriques (6; 8), nécessaires entre les bandes de couches (1', 2', 3', 4') et/ou entre celles-ci et les éléments de surface (7), sont disposées dans le même plan.

13. Puce électronique pour capteur selon l'une des revendications 7 à 12, **caractérisée en ce que** chaque résistance (9) variable est disposée symétriquement par rapport à l'axe médian (15).

14. Puce électronique pour capteur selon la revendication 13, **caractérisée en ce que** la valeur de la résistance (9) est modifiable, par usinage mécanique avec enlèvement de matière.

15. Puce électronique pour capteur selon l'une des revendications 1 à 14, **caractérisée en ce que** le gradient à mesurer de l'intensité de champ magnétique est obtenu par des courants passant dans une ligne électrique (14), disposée et fixée symétriquement par rapport à l'axe médian (15) de la puce électronique pour capteur.
